# EUROPEAN PATENT APPLICATION

(11) **EP 4 513 573 A1**
(43) Date of publication of application: **26.02.2025**
(21) Application number: 23192864.9
(22) Date of filing: 23.08.2023
(51) Int. Cl.: H01L 29/778, H01L 29/786, H01L 27/092, H01L 27/06, H01L 21/8256, H01L 29/08, H01L 29/417

(54) **A 2D MATERIAL BASED SEMICONDUCTOR DEVICE**

(71) Applicant: Huawei Technologies Co., Ltd., Shenzhen, Guangdong 518129 (CN)
(72) Inventor: Bhuwalka, Krishna Kumar, 80992 Munich (DE)
(74) Representative: Roth, Sebastian

(57) **Abstract**

The present disclosure relates to semiconductor devices based on a two-dimensional (2D) channel material (104). The semiconductor device comprises a substrate (101), a gate stack arranged on the substrate, a dielectric material (103) arranged on the substrate, a source contact (105) and drain contact (106) arranged on the substrate, and the 2D material. The gate stack comprises a plurality of stacked gate layers (102). The dielectric material at least partly surrounds the gate stack. The 2D material is formed between each two subsequently stacked gate layers of the gate stack, and extends in between the dielectric material. The source contact and the drain contact are respectively electrically connected to the 2D material.

## Description

### TECHNICAL FIELD

The present disclosure relates to a semiconductor device, for example, to a transistor device. The disclosure is particularly concerned with a semiconductor device that is based on a two-dimensional (2D) material, wherein the 2D material may be the channel material of the transistor device.

### BACKGROUND

2D material-based semiconductor devices are expected to be mainstream in the coming years, due to their advanced scaling properties. The 2D material may be very thin - it can comprise a single monolayer or multiple monolayers - which allows for aggressive device dimension scaling. At the same time, the 2D material provides excellent mobility, which enhances the device performance. Examples of multiple-layer 2D materials have been demonstrated to have excellent mobility as well as short-channel characteristics.

However, the 2D material-based semiconductor devices are prone to a large sensitivity at material interfaces - e.g., a channel-dielectric or channel-contact interface - which may result in a degradation of the device performance. For instance, a large resistance between a source and drain contact and the 2D material channel is problematic in such a semiconductor device.

### SUMMARY

In view of the above, this disclosure aims to provide an improved 2D material-based semiconductor device. An objective is, for example, to avoid a large resistance between the source and the drain contact and the 2D material. Another objective is the ability to tune the device performance of the semiconductor device. Another objective is scalability of the semiconductor device, i.e. the possibility to reach smaller device dimensions.

These and other objectives are achieved by the solutions of this disclosure, as described in the independent claims. Advantageous implementations are further described in the dependent claims.

A first aspect of this disclosure provides a semiconductor device comprising: a substrate; a gate stack arranged on the substrate, wherein the gate stack comprises a plurality of stacked gate layers; a dielectric material arranged on the substrate, wherein the dielectric material at least partly surrounds the gate stack; a 2D material formed between each two subsequently stacked gate layers of the gate stack, wherein the 2D material extends in between the dielectric material; a source contact and a drain contact arranged on the substrate, wherein the gate stack and the dielectric material are arranged between the drain contact and the source contact, and wherein the source contact and the drain contact are respectively electrically connected to the 2D material.

The 2D material, which is distributed between the gate layers of the gate stack, extends through the dielectric material from gate stack to both the source contact and the drain contact. Thus, the 2D material can, on the one hand side, be thin - e.g. one or more monolayers of the 2D material - between subsequent gate layers, which is beneficial for the scalability of the semiconductor device. The mobility of the 2D material can still be high for an excellent device performance, in spite of the 2D material being thin between the gate layers. On the other hand, the 2D material may at the same time be thick at the source and the drain contact - all the one or more monolayers from between the gate stack may contact the source and drain contact - so as to avoid a degraded device performance due to a too large interface resistance between the contacts and the 2D material.

The dielectric material may be a spacer material, which separates and isolates the gate layers (which may also be referred to as gate electrodes) from the source and the drain contact (which may also be referred to as contact electrodes). The dielectric material can be made of SiN, SiOx, a low-k material, or any combination of these materials. The dielectric material may also surround the 2D material channels, i.e., it may separate the 2D material in the gate stack from the gate layers. However, also another gate dielectric or gate oxide may be used to isolate the 2D material and the gate layers of the gate stack form another. The 2D material is usually connected directly to the source contact and the drain contact in the semiconductor device of the first aspect.

In an implementation form of the first aspect, the 2D material between each two subsequently stacked gate layers comprises a plurality of layers.

These layers may be fabricated layer-by-layer, i.e., the number of layers between each two subsequently stacked gate layers can be adjusted as desired. This allows tuning the device performance and the size of the gate stack. The number of layers of 2D material may be the same between each two subsequently stacked gate layers of the gate stack, but may also differ for different pairs of subsequently stacked gate layers. All the layers formed between the gate layers may extend in between the dielectric material, and may electrically connect to the source and the drain contact, respectively. Thus, the number of layers of the 2D material that connects each of the source contact and the drain contact may be higher than the number of layers of 2D material between each particular pair of subsequently stacked gate layers.

In an implementation form of the first aspect, the 2D material between each two subsequently stacked gate layers extends separately from 2D material between other subsequently stacked gate layers in between the dielectric material.

That is, the layers of the 2D material, which are arranged between different pairs of subsequently stacked gate layers, are not physically attached to each other within the dielectric material. The layers may become attached to each other, however, at the source or drain contact.

In an implementation form of the first aspect, the plurality of layers of the 2D material between each two subsequently stacked gate layers extends physically attached together in between the dielectric material.

In an implementation form of the first aspect, all the layers of the 2D material between the stacked gate layers of the gate stack are joined at the source contact and the drain contact, respectively.

This may significantly decrease the interface resistance between the respective contact and the 2D material.

In an implementation form of the first aspect, the 2D material between each two subsequently stacked gate layers comprises two layers.

Another option may provide three layers of the 2D material between each two subsequently stacked gate layers. The number of layers of the 2D material can, however, also be different between different pairs of subsequently stacked gate layers.

In an implementation form of the first aspect, all the layers of the 2D material between the stacked gate layers of the gate stack directly contact a respective side of the source and drain contact, so as to electrically connect to the respective source contact and drain contact.

The layers of the 2D material can be joined before contacting the respective side of the source and the drain contact.

In an implementation form of the first aspect, all the layers of the 2D material between the stacked gate layers of the gate stack are joined between the respective source and drain contact and the substrate, so as to electrically connect together to the respective source contact and drain contact.

The joined layers of the 2D material may contact a respective bottom of the source and the drain contact, respectively.

In an implementation form of the first aspect, a number of layers of the 2D material is arranged on the substrate, and the gate stack is arranged on the number of layers of the 2D material.

In an implementation form of the first aspect, the gate stack comprises two stacked gate layers; and wherein the 2D material between the two stacked gate layers comprises a plurality of layers and each of the plurality of layers extends separately in between the dielectric material.

In this implementation form, the layers of 2D material are not joined at the source and the drain contact as in other implementation forms, but are separated there and are rather joined between the gate layers. The separate layers of the 2D material may be attached and contacted to the respective sides of the source contact and the drain contact.

In an implementation form of the first aspect, the 2D material comprises an MX₂ structure, wherein M is a transition metal selected from the group of molybdenum, tungsten, and titanium, and X is a chalcogen element selected from the group of sulfur, selenium, and tellurium.

A second aspect of this disclosure provides a method for fabricating a semiconductor device, the method comprising: forming a gate stack on a substrate, wherein the gate stack comprises a plurality of stacked gate layers; forming a dielectric material on the substrate, wherein the dielectric material at least partly surrounds the gate stack; forming a two-dimensional, 2D, material between each two subsequently stacked gate layers of the gate stack, wherein the 2D material is formed such that it extends in between the dielectric material; forming a source contact and a drain contact on the substrate, such that the gate stack and the dielectric material are arranged between the drain contact and the source contact, and such that the source contact and the drain contact are respectively electrically connected to the 2D material.

In an implementation form of the second aspect, the 2D material comprises one or more layers and is formed by a layer-by-layer growth process of the 2D material.

In an implementation form of the second aspect, the 2D material between each two subsequently stacked gate layers is formed such that it extends separately from 2D material between other subsequently stacked gate layers in between the dielectric material.

In an implementation form of the second aspect, two or more layers of the 2D material between each two subsequently stacked gate layers are formed such that they extend physically attached together in between the dielectric material.

The method of the second aspect may be extended with further implementation forms, which correspond to the implementation forms of the semiconductor device of the first aspect. The method of the second aspect achieves the same advantages as described above for the semiconductor device of the first aspect.

### BRIEF DESCRIPTION OF DRAWINGS

The above described aspects and implementation forms will be explained in the following description of specific embodiments in relation to the enclosed drawings, in which:
- FIG. 1: shows a semiconductor device according to this disclosure.
- FIG. 2: shows a semiconductor device according to this disclosure including monolayers of 2D material between each two subsequently stacked gate layers.
- FIG. 3: shows a semiconductor device according to this disclosure including multiple layers of 2D material between each two subsequently stacked gate layers, wherein all the layers are connected to a bottom of the source and drain contact.
- FIG. 4: shows a semiconductor device according to this disclosure including multiple layers of 2D material between each two subsequently stacked gate layers, wherein all the layers are connected to a side of the source and drain contact.
- FIG. 5: shows a semiconductor device according to this disclosure including multiple layers of 2D material between each two subsequently stacked gate layers, wherein all the layers are connected to a side and bottom of the source and drain contact.
- FIG. 6: shows a semiconductor device according to this disclosure including multiple layers of 2D material between two subsequently stacked gate layers, which are separately connected to the source and drain contact.
- FIG. 7: shows a method according to an embodiment of this disclosure for fabricating a semiconductor device as shown in the FIGs. 1-6.

### DETAILED DESCRIPTION OF EMBODIMENTS

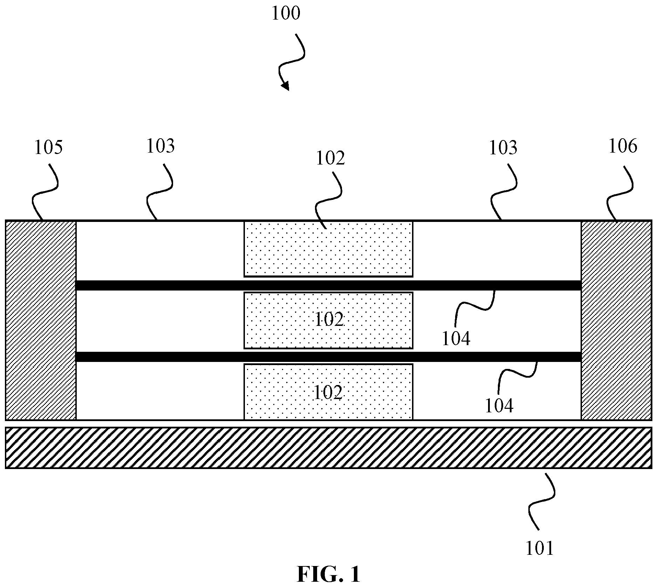

FIG. 1 illustrates a semiconductor device 100 according to this disclosure, in particular, according to a general example. The semiconductor device 100 may be a transistor device, for instance, a field effect transistor (FET) based device. The transistor device may, for instance, be a nanosheet device and/or a complementary FET (CFET) device. The FET device may be a p-type device or an n-type device.

The semiconductor device 100 comprises a substrate 101. The substrate 101 may be made of silicon, a silicon-based semiconductor material, or a silicon-on-insulator (SOI) like structure. The substrate 101 may be a wafer, or may be a thick layer structure.

The semiconductor device 100 further comprises a gate stack, which is arranged on the substrate 101. For instance, the gate stack is grown on the substrate 101. The gate stack does not have to be arranged directly on the substrate 101 (but it could), for example, one or more layers may be arranged between the substrate 101 and the gate stack. The gate stack comprises a plurality of stacked gate layers 102. The gate layers 102 may be stacked along a first direction, which is the vertical direction in FIG. 1. The gate layers 102 may each have a width along a second direction, which is perpendicular to the first direction, i.e., is the horizontal direction in FIG. 1. Each gate layer 102 may have the same width, but gate layers 102 may also have different widths. The gate layers 102 may be made of a material, which allows using the gate layers 102 as gate electrodes in the final semiconductor device 100. To this end, the gate layers 102 may be made of a metal or a highly-conductive, i.e., doped, semiconductor material. The gate layers 102 may be nanosheets. The gate layers 102 may be surrounded by a gate dielectric or gate oxide, for instance, being made of silicon oxide and/or hafnium oxide, and being configured to isolate the gate layers 102.

The semiconductor device 100 further comprises a dielectric material 103, which is arranged on the substrate 100 and at least partly surrounds the gate stack. For instance, the dielectric material 103 may at least sandwich the gate stack in the second direction. The dielectric material 103 may also surround each of the gate layers 102, i.e., it may be present within the gate stack between the gate layers 102. In this case, the dielectric material 103 may form the gate dielectric or gate oxide described above. The dielectric material 103 may, for example, be made of silicon oxide or another oxide.

The semiconductor device further comprises a 2D material 104, for instance, a 2D semiconductor material, which is formed between each two subsequently stacked gate layers 102 of the gate stack. The 2D material is suitable to form transistor channels between the stacked gate layers 102 in the final semiconductor device 100. Accordingly, the 2D material may be highly conductive, and may be insulated from the gate layers 102 by the above-described gate dielectric or gate oxide. The 2D material 104 could comprise an MX₂ structure, wherein M is a transition metal selected from the group of molybdenum, tungsten, and titanium, and X is a chalcogen element selected from the group of sulfur, selenium, and tellurium. The 2D material 104 may be graphene as well. The semiconductor device 100 may be a p-type or n-type device, wherein the 2D material 104 may be p-type or n-type 2D material.

The 2D material 104 extends in between the dielectric material 103, in particular, all the 2D material 104 that is arranged between the gate layers 102 may extend through the dielectric material 103. The semiconductor device 100 further comprises a source contact 105 and a drain contact 106, which are respectively arranged on the substrate 100 and sandwich the dielectric material 103 along the second direction. That is, the gate stack and the dielectric material 103 are arranged between the drain contact 106 and the source contact 105. The source contact 105 and the drain contact 106 are each electrically connected to the 2D material 104, which is achieved by the 2D material extending in between the dielectric material 103 to the source contact 105 and the drain contact 106, respectively.

The gate stack of the semiconductor device 100 may be NMOS or PMOS. Notably, the semiconductor device 100 may comprise more than one gate stack. Multiple gate stacks can be arranged next to each other on the substrate 101. It is also possible to fabricate two gate stacks above each other, i.e., stacked one on the other along the first direction, for instance, to make a CFET. In this case, one gate stack is PMOS and the other gate stack is NMOS, where the order is not important.

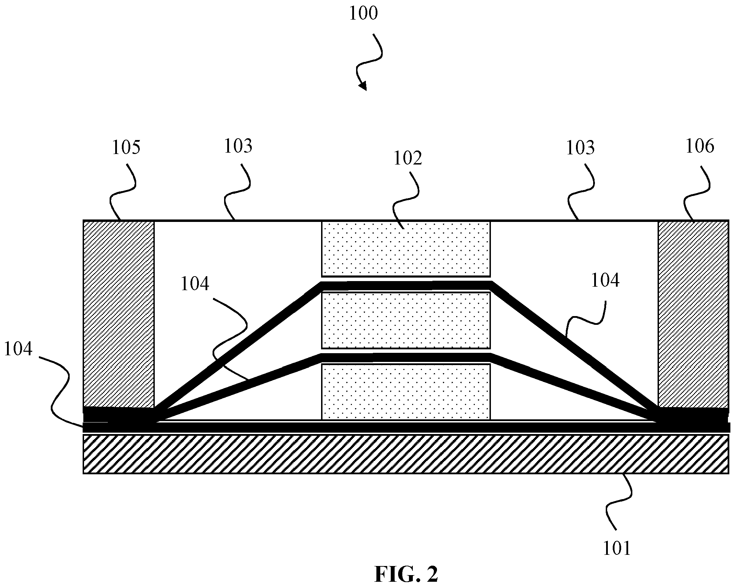

FIG. 2 shows a semiconductor device 100 according to this disclosure, which builds on the semiconductor device 100 of FIG. 1. Same elements in FIG. 1 and FIG. 2 share the same reference signs, and may be implemented likewise.

FIG. 2 shows a semiconductor device 100, in which the 2D material 104 between each two subsequently stacked gate layers 102 is a monolayer. Generally, the 2D material 104 between each two subsequently stacked gate layers 102 may comprise one or more layers of the 2D material 104 formed on another, especially one or more monolayers. The 2D material 104 may be formed by a layer-by-layer growth process of the 2D material 104 - for instance, using chemical vapor deposition (CVD), physical vapor deposition (PVD), plasma-enhanced CVD (PECVD), molecular beam epitaxy (MBE), or atomic layer deposition (ALD).

As can be seen in FIG. 2, the 2D material 104 between each two subsequently stacked gate layers 102 extends separately from the 2D material 104 between other subsequently stacked gate layers 102 in between the dielectric material 103. That is, each monolayer of the 2D material 104 extends separately in between the dielectric material 103. The monolayers are separated at the gate stack, and are joined at the contact regions, e.g., at or shortly before the source contact 105 and the drain contact 106, respectively. Further as shown, all the monolayers of the 2D material 104 can be joined between the respective source contact 105 and drain contact 106 and the substrate 101, so as to electrically connect together to the respective source contact 105 and drain contact 106 at the bottom (the end of the contacts closer to the substrate 101). Thus, the monolayers of the 2D material 104 may be arranged, while being joined together, between the substrate 101 and the source contact 105 and drain contact 106, respectively.

As can be further derived from FIG. 2, a number of layers of the 2D material 104 - e.g. one or more monolayers - may be arranged on the substrate 101, and the gate stack may be arranged on the number of layers of the 2D material 104. That is, 2D material 204 may be formed between the substrate 101 and the gate stack (i.e., the first gate layer 102 of the gate stack). This number of layers of the 2D material 104 may be joined with the other layers between the gate layers 102, at or before the source and drain contacts 105, 106.

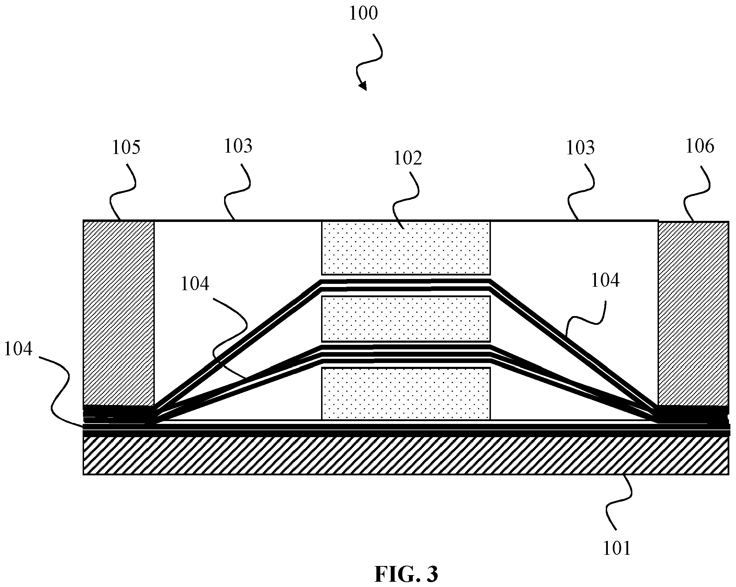

FIG. 3 shows a semiconductor device 100 according to this disclosure, which builds on the semiconductor devices 100 of FIG. 1. Same elements in FIG. 1 and FIG. 3 share the same reference signs, and may be implemented likewise.

FIG. 3 shows a semiconductor device 100, in which multiple layers of 2D material 104 - in particular multiple monolayers of the 2D material 104 - are arranged between each two subsequently stacked gate layers 102. All of these (mono) layers of the 2D material 104 are connected in FIG. 3 to a respective bottom of the source and drain contact 105, 106, i.e., are arranged, while being joined together, between the substrate 101 and the respective source contact 105 and drain contact 106.

It can also be seen in FIG. 3 that the plurality of layers of the 2D material 104 between each two subsequently stacked gate layers 102 extends physically attached together in between the dielectric material 103. However, the plurality of layers of the 2D material 104 between each two subsequently stacked gate layers 102 extends separately from other pluralities of layers of the 2D material 104 between other subsequently stacked gate layers 102 in between the dielectric material 103. In other words, the (mono) layers of the 2D material 104 that are joined in the gate stack stay joined while extending through the dielectric material 103, while the (mono) layers of the 2D material 104 that are separated in the gate stack stay separated while extending in between the dielectric material 103.

The number of the layers of 2D material 104 between different pairs of the gate layers 102 may be the same or may differ. For instance, the number of layers of the 2D material 104 may be two layers between one pair of subsequently stacked gate layers 102, but may be three layers between another pair of subsequently stacked gate layers 102, as shown in FIG. 3. However, the 2D material 104 between each two subsequently stacked gate layers 102 of the gate stack could comprise two layers, or three layers, or even more layers.

All the layers of the 2D material 104 between the stacked gate layers 102 of the gate stack are again joined at the respective source and drain contact 105, 106. For instance, as shown in FIG. 3, between the respective source and drain contact 105, 106 and the substrate 101. The joined layers of the 2D material 104 electrically connect together to the respective source contact 105 and drain contact 106.

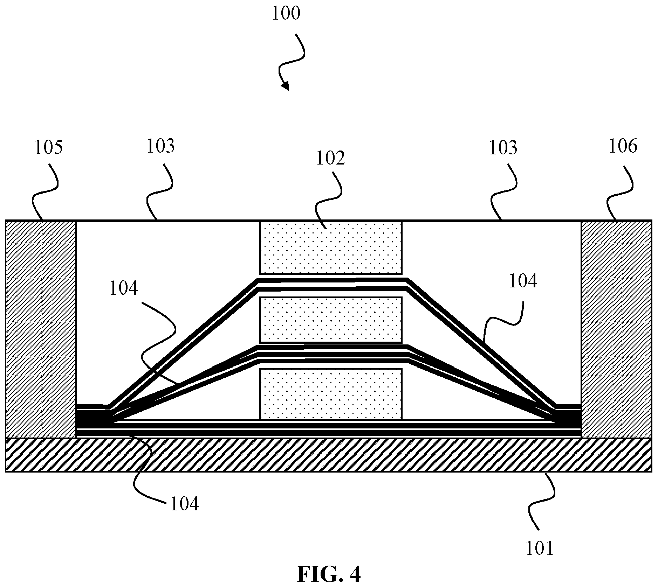

FIG. 4 shows a semiconductor device 100 according to this disclosure, which builds on the semiconductor devices 100 of FIG. 1. Same elements in FIG. 1 and FIG. 4 share the same reference signs, and may be implemented likewise.

FIG. 4 shows a semiconductor device 100, in which multiple layers of 2D material 104 between each two subsequently stacked gate layers, like in FIG. 3. Also, the extension of these layers of the 2D material 104 through the dielectric material 103 is largely similar to that of FIG. 3.

In contrast to FIG. 3, however, in the semiconductor device 100 of FIG. 4, all the layers of the 2D material 104 are connected to a respective side of the source and drain contact 105, 106. That is, all the layers of the 2D material 104 between the stacked gate layers 102 of the gate stack directly contact a respective side (facing in the second direction) of the source and drain contact 105, 106, so as to electrically connect to the respective source contact 105 and the drain contact 106. All the layers of the 2D material 104 between the stacked gate layers 102 of the gate stack are again joined at the source contact 105 and the drain contact 106, in particular, before contacting the respective side of the source contact 105 and the drain contact 106.

This side contact scheme shown in FIG. 4 may be achieved by forming the source contact 105 and the drain contact 106 all the way down to the substrate 101. For instance, after depositing the 2D material 104 and the dielectric material 103, a respective trench may be etched from the top all the way down to the substrate 101, and the source contact material and the drain contact material may be filled into the respective trench. Notably, although the etching may be through the 2D material 104, one or more layers of other material may still remain between the substrate 101 and the source contact material and drain contact material, respectively. The bottom contact scheme of FIG. 2 and FIG. 3 may be achieved by forming a trench only to the 2D material 104, and depositing the source contact material and drain contact material onto the 2D material 104.

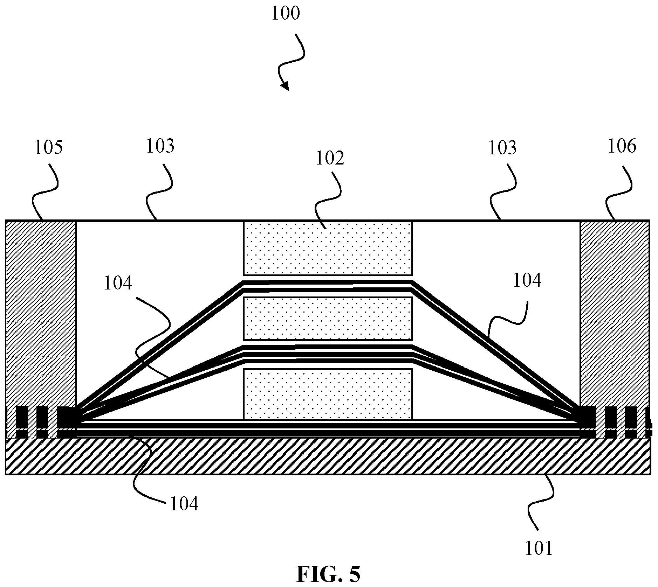

FIG. 5 shows a semiconductor device 100 according to this disclosure, which builds on the semiconductor device 100 of FIG. 1. Same elements in FIG. 1 and FIG. 5 share the same reference signs, and may be implemented likewise.

FIG. 5 shows a semiconductor device 100, in which multiple layers of 2D material 104, in particular, multiple monolayers of the 2D material 104, are arranged between each two subsequently stacked gate layers, like in FIG. 3 and FIG 4. Also, the extension of these layers of the 2D material 104 through the dielectric material 103 is largely similar to that of FIG. 3 and FIG. 4.

In contrast to FIG. 3 and FIG. 4, in the semiconductor device 100 of FIG. 5, all the layers of the 2D material 104 are connected to a respective side of the source contact 105 and drain contact 106, and in addition also to parts of a respective bottom of the source contact 105 and drain contact 106. The contacting scheme is thus kind of a mixture of the side and bottom contact schemes of FIG. 3 and FIG. 4.

The side-and-bottom contact scheme shown in FIG. 5 may be achieved by forming the source contact 105 and the drain contact 106 only partly all the way down to the substrate 101. For instance, after depositing the 2D material 104 and the dielectric material 103, multiple respective thin trenches may be etched from the top all the way down to the substrate 101 for each of the source contact material and the drain contact material, and the source contact material and the drain contact material may then be filled into the respective thin trenches. In this way, an even improved S/D resistance may be achieved.

The semiconductor devices 100 of the FIGs. 2-5 show superior short-channel effects brought by the 2D material 104, and show a non-problematic resistance between the source contact 105 and the 2D material 104 and, respectively, between the drain contact 106 and the 2D material 104 (also referred to as source/drain (S/D) resistance). The semiconductor device 100 exhibits reduced source starvation.

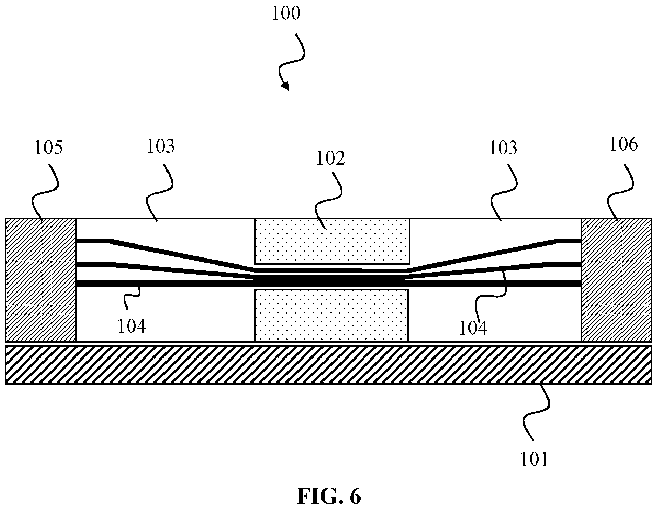

FIG. 6 shows a semiconductor device 100 according to this disclosure, which builds on the semiconductor device 100 of FIG. 1. Same elements in FIG. 1 and FIG. 6 share the same reference signs, and may be implemented likewise.

FIG. 6 shows a semiconductor device 100, in which multiple layers of 2D material 104 are arranged between two subsequently stacked gate layers 102, and the multiple layers of the 2D material 104 are separately connected to the source and drain contact 105, 106. The gate stack comprises two stacked gate layers 102 in this semiconductor device 100. The 2D material 104 between these two stacked gate layers 102 comprises a plurality of layers, in particular, monolayers. Each of these layers of the plurality of layers of the 2D material 104 extends separately in between the dielectric material 103. In other words, the 2D material layers are joined at the gate stack, but are separated at the source and drain contact 105, 106. The contacting scheme to the source and drain contact 105, 106 is accordingly from the side. That is, all the layers of the 2D material 104 are connected to a respective side of the source and drain contact 105, 106.

The semiconductor device 100 of FIG. 6 shows improved mobility in the channel, and thus better transport properties.

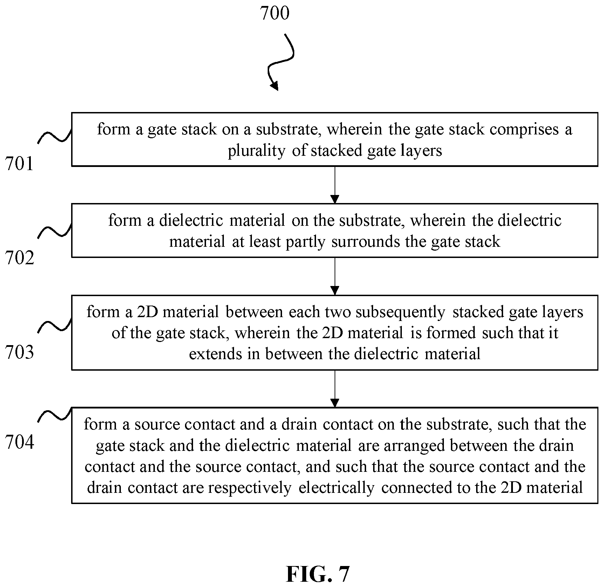

FIG. 7 shows a method 700 according to an embodiment of this disclosure, which may be used for fabricating a semiconductor device 100 as shown in the FIGs. 1-6. The method 700 may comprise a step 701 of forming a gate stack on a substrate 101. The gate stack comprises a plurality of stacked gate layers 102, which are accordingly formed one above the other, e.g., along the first direction. The gate layers 102 may be formed using a suitable deposition or growth technique, like CVD, MBE or the like. The method 700 further comprises a step 702 of forming a dielectric material 103 on the substrate 101, wherein the dielectric material 103 at least partly surrounds the gate stack, in particular, sandwiches the gate stack along the second direction.

The method 700 also comprises a step 703 of forming a 2D material 104 between each two subsequently stacked gate layers 102 of the gate stack. The 2D material 104 may be formed by a layer-by-layer growth process of the 2D material 104, in particular, if it comprises multiple monolayers between subsequently stacked gate layers 102. The 2D material 104 is formed such that it extends in between the dielectric material 103. Notably, the order of forming the gate layers 102, dielectric material 103, and 2D material 104 is not specific in this disclosure. The 2D material 104 could be formed while forming the gate layers 102 of the gate stack. The dielectric material 103 could be formed afterwards. However, the gate layers 102, the 2D material 104, and dielectric material 103 may also be formed alternately, for instance, if the dielectric material 103 forms also a gate dielectric or gate oxide between the gate layers 102 and the 2D material 104.

The method 700 further comprises a step 704 of forming a source contact 105 and a drain contact 106 on the substrate 101, such that the gate stack and the dielectric material 103 are arranged between the drain contact 106 and the source contact 105, and such that the source contact 105 and the drain contact 106 are respectively electrically connected to the 2D material 104. The forming of the source contact 105 and the drain contact 106 may comprise etching through the dielectric material 103 and optionally the 2D material 104. For instance, one or more trenches may be formed and filled with dielectric material 103, as described above.

The present disclosure has been described in conjunction with various embodiments as examples as well as implementations. However, other variations can be understood and effected by those persons skilled in the art and practicing the claimed matter, from the studies of the drawings, this disclosure and the independent claims. In the claims as well as in the description the word "comprising" does not exclude other elements or steps and the indefinite article "a" or "an" does not exclude a plurality. A single element or other unit may fulfill the functions of several entities or items recited in the claims. The mere fact that certain measures are recited in the mutual different dependent claims does not indicate that a combination of these measures cannot be used in an advantageous implementation.

## Claims

1. A semiconductor device (100) comprising:
a substrate (101);
a gate stack arranged on the substrate (101), wherein the gate stack comprises a plurality of stacked gate layers (102);
a dielectric material (103) arranged on the substrate (101), wherein the dielectric material (103) at least partly surrounds the gate stack;
a two-dimensional, 2D, material (104) formed between each two subsequently stacked gate layers (102) of the gate stack, wherein the 2D material (104) extends in between the dielectric material (103);
a source contact (105) and a drain contact (106) arranged on the substrate (100), wherein the gate stack and the dielectric material (103) are arranged between the drain contact (106) and the source contact (105), and
wherein the source contact (105) and the drain contact (106) are respectively electrically connected to the 2D material (104).

2. The semiconductor device (100) of claim 1, wherein the 2D material (104) between each two subsequently stacked gate layers (102) extends separately from 2D material (104) between other subsequently stacked gate layers (102) in between the dielectric material (103).

3. The semiconductor device (100) of claim 1 or 2, wherein the 2D material (104) between each two subsequently stacked gate layers (102) comprises a plurality of layers.

4. The semiconductor device (100) of claim 3, wherein the plurality of layers of the 2D material (104) between each two subsequently stacked gate layers (102) extends physically attached together in between the dielectric material (103).

5. The semiconductor device (100) of claim 3 or 4, wherein all the layers of the 2D material (104) between the stacked gate layers (102) of the gate stack are joined at the source contact (105) and the drain contact (106), respectively.

6. The semiconductor device (100) of any one of the claims 3 to 5, wherein all the layers of the 2D material (104) between the stacked gate layers (102) of the gate stack are joined between the respective source and drain contact (105, 106) and the substrate (101), so as to electrically connect together to the respective source contact (105) and drain contact (106).

7. The semiconductor device (100) of claims 1 or 2, wherein:
the gate stack comprises two stacked gate layers (102);
the 2D material (104) between the two stacked gate layers (102) comprises a plurality of layers; and
each layer of the plurality of layers of the 2D material (104) extends separately in between the dielectric material (103).

8. The semiconductor device (100) of any one of the claims 1 to 7, wherein the 2D material (104) between each two subsequently stacked gate layers (102) comprises two layers.

9. The semiconductor device (100) of any one of the claims 2 to 8, wherein all the layers of the 2D material (104) between the stacked gate layers (102) of the gate stack directly contact a respective side of the source and drain contact (105, 106), so as to electrically connect to the respective source contact (105) and drain contact (106).

10. The semiconductor device (100) of any one of the claims 1 to 9, wherein:
a number of layers of the 2D material (104) is arranged on the substrate (101), and the gate stack is arranged on the number of layers of the 2D material (104).

11. The semiconductor device (100) of any one of the claims 1 to 10, wherein the 2D material (104) comprises an MX₂ structure, wherein M is a transition metal selected from the group of molybdenum, tungsten, and titanium, and X is a chalcogen element selected from the group of sulfur, selenium, and tellurium.

12. A method (700) for fabricating a semiconductor device (100), the method (700) comprising:
forming (701) a gate stack on a substrate (101), wherein the gate stack comprises a plurality of stacked gate layers (102);
forming (702) a dielectric material (103) on the substrate (101), wherein the dielectric material (103) at least partly surrounds the gate stack;
forming (703) a two-dimensional, 2D, material (104) between each two subsequently stacked gate layers (102) of the gate stack, wherein the 2D material (104) is formed such that it extends in between the dielectric material (103);
forming (704) a source contact (105) and a drain contact (106) on the substrate (101), such that the gate stack and the dielectric material (103) are arranged between the drain contact (106) and the source contact (105), and such that the source contact (105) and the drain contact (106) are respectively electrically connected to the 2D material (104).

13. The method (700) of claim 12, wherein the 2D material (104) comprises one or more layers and is formed by a layer-by-layer growth process of the 2D material (104).

14. The method (700) of claim 12 or 13, wherein the 2D material (104) between each two subsequently stacked gate layers (102) is formed such that it extends separately from 2D material (104) between other subsequently stacked gate layers (102) in between the dielectric material (103).

15. The method (700) of any one of the claims 12 to 14, wherein two or more layers of the 2D material (104) between each two subsequently stacked gate layers (102) are formed such that they extend physically attached together in between the dielectric material (103).

## Amended claims

### Amended claims in accordance with Rule 137(2) EPC.

1. A semiconductor device (100) comprising:
a substrate (101);
a gate stack arranged on the substrate (101), wherein the gate stack comprises a plurality of stacked gate layers (102);
a dielectric material (103) arranged on the substrate (101), wherein the dielectric material (103) at least partly surrounds the gate stack;
a two-dimensional, 2D, material (104) formed between each two subsequently stacked gate layers (102) of the gate stack, wherein the 2D material (104) extends in between the dielectric material (103);
a source contact (105) and a drain contact (106) arranged on the substrate (100), wherein the gate stack and the dielectric material (103) are arranged between the drain contact (106) and the source contact (105), and
wherein the source contact (105) and the drain contact (106) are respectively electrically connected to the 2D material (104) at their respective bottom.

2. The semiconductor device (100) of claim 1, wherein the 2D material (104) between each two subsequently stacked gate layers (102) extends separately from 2D material (104) between other subsequently stacked gate layers (102) in between the dielectric material (103).

3. The semiconductor device (100) of claim 1 or 2, wherein the 2D material (104) between each two subsequently stacked gate layers (102) comprises a plurality of layers.

4. The semiconductor device (100) of claim 3, wherein the plurality of layers of the 2D material (104) between each two subsequently stacked gate layers (102) extends physically attached together in between the dielectric material (103).

5. The semiconductor device (100) of claim 3 or 4, wherein all the layers of the 2D material (104) between the stacked gate layers (102) of the gate stack are joined at the source contact (105) and the drain contact (106), respectively.

6. The semiconductor device (100) of any one of the claims 3 to 5, wherein all the layers of the 2D material (104) between the stacked gate layers (102) of the gate stack are joined between the respective source and drain contact (105, 106) and the substrate (101), so as to electrically connect together to the respective source contact (105) and drain contact (106).

7. The semiconductor device (100) of any one of the claims 1 to 6, wherein the 2D material (104) between each two subsequently stacked gate layers (102) comprises two layers.

8. The semiconductor device (100) of any one of the claims 2 to 7, wherein all the layers of the 2D material (104) between the stacked gate layers (102) of the gate stack directly contact a respective side of the source and drain contact (105, 106), so as to electrically connect to the respective source contact (105) and drain contact (106).

9. The semiconductor device (100) of any one of the claims 1 to 8, wherein:
a number of layers of the 2D material (104) is arranged on the substrate (101), and the gate stack is arranged on the number of layers of the 2D material (104).

10. The semiconductor device (100) of any one of the claims 1 to 9, wherein the 2D material (104) comprises an MX₂ structure, wherein M is a transition metal selected from the group of molybdenum, tungsten, and titanium, and X is a chalcogen element selected from the group of sulfur, selenium, and tellurium.

11. A method (700) for fabricating a semiconductor device (100), the method (700) comprising:
forming (701) a gate stack on a substrate (101), wherein the gate stack comprises a plurality of stacked gate layers (102);
forming (702) a dielectric material (103) on the substrate (101), wherein the dielectric material (103) at least partly surrounds the gate stack;
forming (703) a two-dimensional, 2D, material (104) between each two subsequently stacked gate layers (102) of the gate stack, wherein the 2D material (104) is formed such that it extends in between the dielectric material (103);
forming (704) a source contact (105) and a drain contact (106) on the substrate (101), such that the gate stack and the dielectric material (103) are arranged between the drain contact (106) and the source contact (105), and such that the source contact (105) and the drain contact (106) are respectively electrically connected to the 2D material (104) at their respective bottom.

12. The method (700) of claim 11, wherein the 2D material (104) comprises one or more layers and is formed by a layer-by-layer growth process of the 2D material (104).

13. The method (700) of claim 11 or 12, wherein the 2D material (104) between each two subsequently stacked gate layers (102) is formed such that it extends separately from 2D material (104) between other subsequently stacked gate layers (102) in between the dielectric material (103).

14. The method (700) of any one of the claims 11 to 13, wherein two or more layers of the 2D material (104) between each two subsequently stacked gate layers (102) are formed such that they extend physically attached together in between the dielectric material (103).
